# DEMANDE DE BREVET EUROPEEN

(11) **EP 2 843 693 A1**
(43) Date de publication de la demande: **04.03.2015**
(21) Numéro de dépôt: 14178105.4
(22) Date de dépôt: 23.07.2014
(51) Int. Cl.: H01L 21/60, H01L 21/768, H01L 21/48, H01L 23/485, H01L 23/31

(54) **Procédé de réalisation d'un plot conducteur sur un élément conducteur**

(30) Priorité: 25.07.2013 FR 1357328
(71) Demandeur: COMMISSARIAT A L'ENERGIE ATOMIQUE ET AUX ENERGIES ALTERNATIVES, 75015 Paris (FR)
(72) Inventeur: Colonna, Jean-Philippe, 38700 CORENC (FR); Coudrain, Perceval, 38000 GRENOBLE (FR)
(74) Mandataire: Decobert, Jean-Pascal

(57) **Abrégé**

L'invention concerne un procédé de réalisation d'un plot d'interconnexion (125) sur un élément conducteur (100) comprenant une face supérieure et une paroi latérale ; le procédé étant réalisé à partir d'un substrat (50) dont au moins la face supérieure est isolante ; l'élément conducteur (100) traversant au moins une partie isolante du substrat (50), le procédé étant caractérisé en ce qu'il comprend la séquence d'étapes suivantes : une étape de mise en relief de l'élément conducteur (100), une étape de formation au-dessus de la face supérieure isolante du substrat (50) d'un empilement de couches comportant au moins une couche électriquement conductrice (120) et une couche électriquement résistive (130), une étape de retrait partiel de la couche électriquement résistive (130), une étape de croissance électrolytique sur la partie de la couche électriquement conductrice (120) de sorte à former au moins un plot d'interconnexion (125) sur ledit élément conducteur (100).

## Description

### DOMAINE DE L'INVENTION

La présente invention est relative à un schéma d'intégration tridimensionnelle de systèmes à plusieurs niveaux, où différents composants sont empilés et interconnectés grâce à des vias verticaux, traversant les étages d'un substrat. La présente invention concerne, plus particulièrement, la formation de plots d'interconnexion à partir desdits vias traversants ou éléments conducteurs.

L'invention s'applique à l'industrie de la microélectronique ; ce qui couvre aussi bien les techniques de la microélectronique que de la nanoélectronique.

### ARRIERE-PLAN TECHNOLOGIQUE

Afin de suivre l'évolution constante de l'industrie microélectronique visant à une réduction significative des dimensions des dispositifs, un procédé d'intégration tridimensionnelle (3D) a été adopté. Outre le fait de permettre une augmentation importante des performances circuits et une réduction de leurs consommations énergétiques, l'intégration 3D permet aussi de réduire les coûts de production. Ceci à condition de disposer de procédés 3D suffisamment matures et robustes technologiquement.

L'application de la présente invention vise une intégration 3D à forte densité d'interconnexions. Un procédé d'intégration 3D peut se décomposer en trois parties distinctes: une première partie correspondant à la fabrication d'éléments conducteurs ou vias traversants (dits TSV, en anglais pour « Through-Silicon Vias » ou « TGV » pour « Through-Glass Vias »), une seconde partie correspondant à la réalisation des interconnexions, et enfin une troisième partie correspondant au report des puces.

La présente invention concerne essentiellement la réalisation de plots d'interconnexions. Avantageusement, on part de plaques comprenant un substrat, en particulier de silicium, sur lesquelles les dispositifs ont été réalisés avec une technologie de type « vias first » ou « vias middle ». Dans la technologie dite « vias middle », les éléments conducteurs vias possèdent des dimensions très réduites, permettant d'adresser des applications requérant une densité d'interconnexions plus élevée. La technologie «vias first », encore en développement, offrira à plus long terme des possibilités d'intégration plus poussées, et peut s'adapter à des contraintes applicatives très importantes (fortes isolations, tensions élevées).

La technologie « face arrière » que l'on réalise ensuite sur ces plaques commence, par exemple, avec un collage temporaire sur un substrat de silicium ou sur du verre, ou toute autre technique permettant d'affiner la face arrière des plaques avec des éléments conducteurs vias. L'amincissement des plaques avec des éléments conducteurs vias se fait classiquement par polissage ou rectification (« grinding » en anglais), suivi d'une étape de relaxation des contraintes par exemple par polissage mécano-chimique (CMP, en anglais pour Chemical Mechanical Polishing). L'étape de « grinding » consiste donc à amincir les plaques avec des éléments conducteurs vias à partir de la face arrière et s'arrête à quelques microns au-dessus de l'arrière des éléments conducteurs vias (l'arrière des éléments conducteurs vias est également appelé « copper nails » en anglais). L'ouverture de l'arrière des éléments conducteurs ou « via reveal » peut être réalisée par polissage mécano-chimique. Cependant, il existe d'autres techniques telles que la gravure ionique réactive (RIE, en anglais pour Reactive-Ion Etching) ou encore une attaque chimique à base d'hydroxyde de tetramethylammonium (TMAH) ou encore d'un mélange à base d'acide fluorhydrique et d'acide nitrique (HF/HNO₃), par exemple. L'étape de « via reveal » se fait par une gravure à base d'hexafluorure de soufre (SF₆), suivie d'un dépôt d'une couche diélectrique permettant d'isoler les futures interconnexions du substrat de silicium. Il peut s'agir d'un diélectrique minéral choisi parmi le dioxyde de silicium (SiO₂) ou le nitrure de silicium (SiN), pouvant être déposé par dépôt chimique en phase vapeur (CVD, en anglais pour Chemical Vapor Deposition) ou d'une résine diélectrique (étalée à la tournette ou « spin-on »). L'ouverture des éléments conducteurs vias est ensuite réalisée par polissage mécano-chimique. Enfin, la dernière étape consiste à réaliser des interconnexions appelées micro-piliers (micro-pillar en anglais).

Les étapes technologiques servant à réaliser ces interconnexions sont d'abord le dépôt d'une couche d'accroche ou couche barrière, puis une seconde couche métallique de résistivité plus faible, soit une bicouche à base, par exemple de titane et de cuivre. Il s'ensuit une étape de lithographie servant à définir les zones d'interconnexions (étalement puis développement de la résine). Ensuite, une croissance par électrolyse du plot d'interconnexion (en cuivre ou en nickel, par exemple) est réalisée. Puis, la résine est retirée (« stripping » en anglais). Le procédé se termine par une gravure de la couche barrière, puis de la couche métallique de résistivité plus faible par une attaque chimique, par exemple.

Une intégration en face arrière est présentée dans l'article de P. Coudrain et al., intitulé : « Towards Efficient and Reliable 300mm 3D Technology for Wide I/O Interconnects », publié dans les « Proceedings of the Electroics Packaging Technology Conférence (EPTC) », pp. 335-340, Décembre 05-07 2012, Singapour.

Dans le procédé décrit précédemment, une étape de lithographie est réalisée pour définir les zones d'interconnexions au-dessus des éléments conducteurs TSV. L'alignement se fait visuellement sur les éléments conducteurs TSV, pour une dimension critique de quelques microns.

L'inconvénient de cette approche réside dans les contraintes d'alignement, lors d'une étape de lithographie, sur des dispositifs micrométriques, voire nanométriques. Ces imprécisions d'alignement sont dues à la fois à la technique propre du positionnement du masque, mais aussi à cause des effets de dilatation thermique (différents coefficients de dilatation entre le masque et le substrat de silicium).

L'étape de lithographie peut s'accompagner également de problèmes de compatibilité entre la résine et les bains d'électrolyse. Ces incompatibilités peuvent engendrer des décollements de la résine ou des modifications de la pente de la résine, ayant pour conséquences des infiltrations dans les bains lors d'un dépôt par voie électrolytique (ECD, en anglais pour Electro-Chemical Deposition), ou bien des problèmes d'adhérence.
Cette technique est valable pour les dimensions actuelles de TSV qui ont un diamètre de l'ordre de 10 micromètres (micromètre ou micron = 10⁻⁶ mètre).

En outre, afin de répondre aux demandes concernant des dispositifs dont les dimensions sont de plus en plus réduites, il faudrait envisager des techniques de lithographies plus fines. Cela constituerait un changement majeur pour l'intégration « face arrière » puisque cela nécessiterait de repenser entièrement la stratégie d'alignement.

Un inconvénient supplémentaire est la multiplicité d'étapes technologiques et de contrôles associés (étalement de la résine, premier recuit, insolation, développement, deuxième recuit, retrait de la résine, etc.) que requiert une étape de lithographie.

Le document US-A1-20100096738 décrit une méthode dans laquelle un via traversant est exposé en saillie par l'une des faces d'un dispositif de sorte à permettre la croissance d'un élément destiné à servir de perle de soudure (en anglais : solder bump), après refusion. Le choix des matériaux impliqués par ce procédé est limité. En outre, le via est fragilisé par l'étape de mise en saillie comme le montre la figure 4A de ce document, ce qui réduit, soit sa résistance mécanique finale, soit limite les hauteurs de mise en saillie du via.

La présente invention permet de résoudre tout ou, du moins, une partie des inconvénients des techniques actuelles.

### RESUME DE L'INVENTION

La présente invention permet d'éviter une étape de lithographie dans le procédé de réalisation d'un plot conducteur sur un élément conducteur de type TSV, et de la remplacer par une croissance d'interconnexions auto-alignées sur de tels éléments conducteurs.

Un aspect de l'invention est relatif à un procédé de réalisation d'un plot d'interconnexion sur un élément conducteur comprenant une face supérieure et une paroi latérale ; le procédé étant réalisé à partir d'un substrat dont au moins la face supérieure est isolante ; l'élément conducteur traversant au moins une partie isolante du substrat, le procédé étant caractérisé en ce qu'il comprend la séquence d'étapes suivantes :
- une étape de mise en relief de l'élément conducteur configurée pour que l'élément conducteur forme saillie au-delà de la face supérieure isolante du substrat,
- une étape de formation au-dessus de la face supérieure isolante du substrat d'un empilement de couches comportant au moins une couche électriquement conductrice et une couche électriquement résistive; ladite couche électriquement résistive ayant une résistivité supérieure à celle de la couche électriquement conductrice,

- une étape de retrait partiel de la couche électriquement résistive configurée pour ouvrir au moins un accès à la couche électriquement conductrice, disposé au-dessus de l'élément conducteur en saillie, ladite étape comprenant de préférence un polissage de ladite couche électriquement résistive,
- une étape de croissance électrolytique sur la partie de la couche électriquement conductrice, disposée au-dessus de l'élément conducteur, de sorte à former au moins un plot d'interconnexion sur ledit élément conducteur.

Ainsi, est réalisé un plot d'interconnexion sur un élément conducteur selon un procédé qui, de manière particulièrement avantageuse, n'est pas sujet aux limitations rencontrées lors d'étapes de lithographie, et, notamment aux tolérances d'alignement.

En outre, de manière avantageuse, la couche électriquement conductrice reste en place au-dessus de l'élément conducteur, en recouvrant la face supérieure de ce dernier, pour l'étape de croissance électrolytique. La croissance est ainsi optimisée et le bout de l'élément conducteur est mécaniquement protégé.

Grâce à l'invention, on simplifie la fabrication en évitant des étapes de lithographie et, en même temps, on augment l'efficacité de la croissance, tout en protégeant correctement l'élément conducteur.

Un autre aspect de mode de réalisation de l'invention est un dispositif microélectronique, ce dernier pouvant non limitativement être obtenu en mettant en oeuvre au moins une des étapes du procédé de l'invention.

### BREVE INTRODUCTION DES FIGURES

Les buts, objets, ainsi que les caractéristiques et avantages de l'invention ressortiront mieux de la description détaillée d'un mode de réalisation de cette dernière, qui est illustré par les dessins d'accompagnement suivants, dans lesquels :
Les figures 1a et 1b illustrent une représentation d'un élément conducteur préalablement formé à partir d'un substrat.
Les figures 2 à 8 illustrent des étapes technologiques du procédé standard de réalisation de plots d'interconnexions selon la technique connue, et dans lequel intervient une étape de lithographie.
Les figures 9 à 15 illustrent les étapes d'un procédé selon un exemple de réalisation de l'invention, permettant notamment de former des plots d'interconnexions sans aucune contrainte d'alignement. Plus précisément :

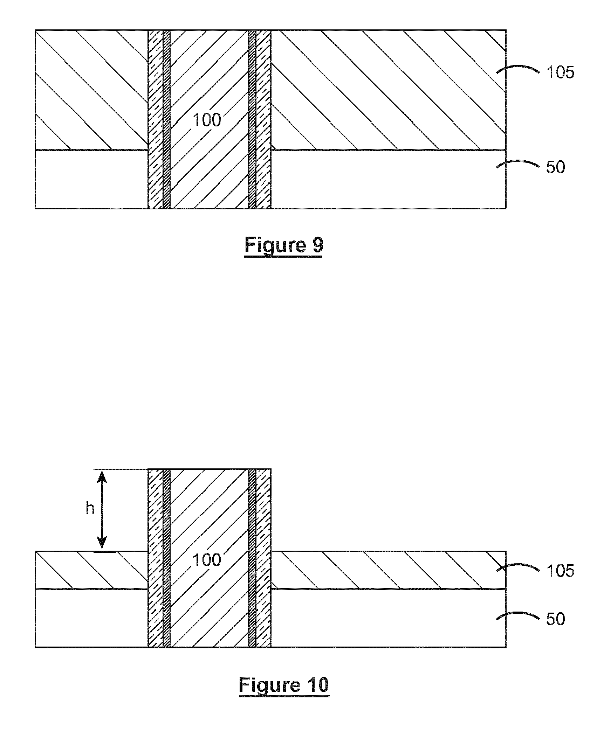

   - la figure 9 illustre un substrat comportant, en surface, une couche diélectrique et un élément conducteur comprenant une face supérieure et une paroi latérale ;
   - la figure 10 illustre une étape mise en relief de l'élément conducteur au terme de laquelle l'élément conducteur forme saillie et traverse la couche diélectrique ;

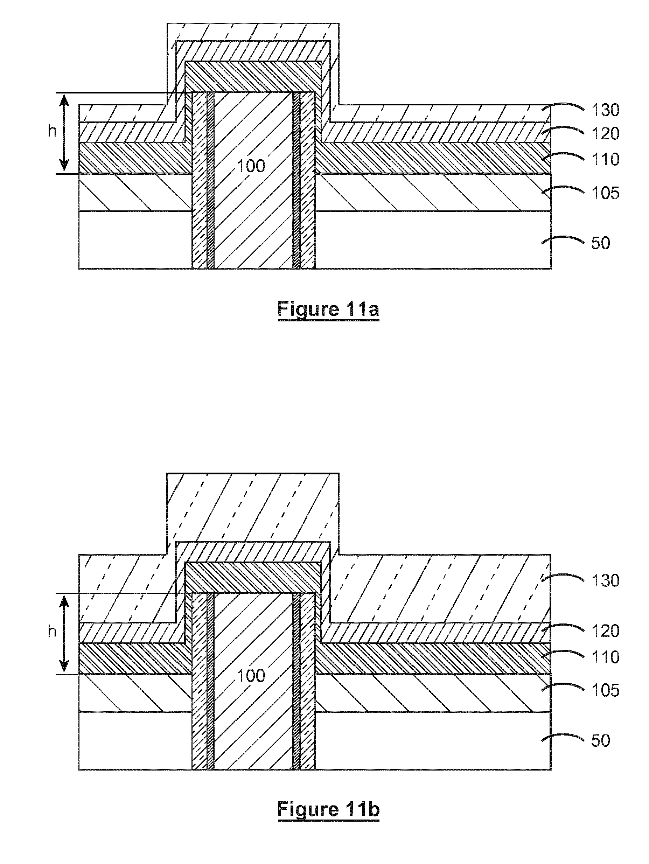

   - les figures 11 a et 11 b illustrent une étape de déposition, sur le substrat, d'un empilement successif de couches : une couche d'accroche optionnelle, une couche électriquement conductrice et une couche électriquement résistive.

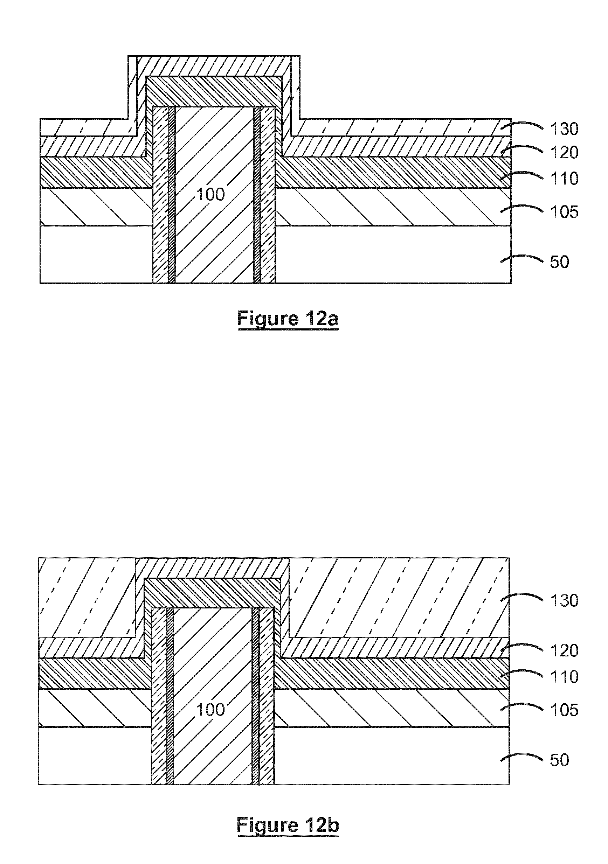

   - les figures 12a et 12b illustrent une étape de retrait partiel de la couche électriquement résistive de sorte à ouvrir un accès à la couche électriquement conductrice, située au-dessus de l'élément conducteur en saillie.

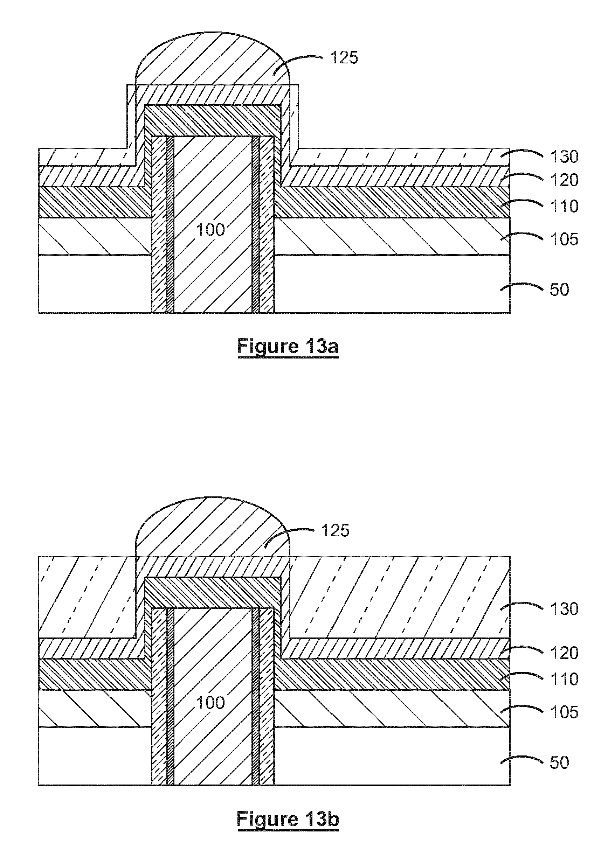

   - les figures 13a et 13b illustrent une étape de croissance électrolytique au terme de laquelle est formé un plot conducteur, à partir de la couche électriquement conductrice au-dessus de l'élément conducteur.

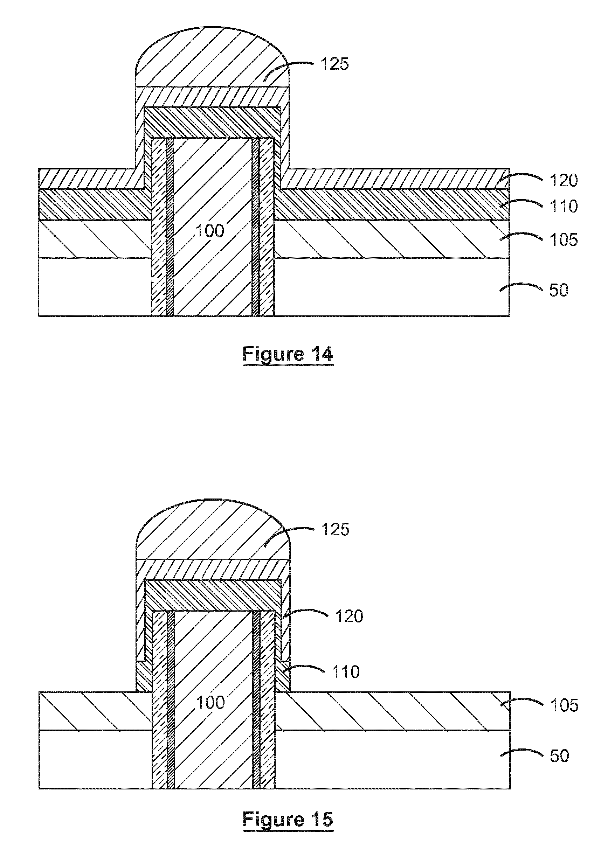

   - la figure 14 illustre une étape de retrait de la couche électriquement résistive.
   - la figure 15 illustre une étape de retrait de la couche électriquement conductrice et, optionnellement une étape de retrait de la couche d'accroche.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs relatives des différentes couches et films ne sont pas représentatives de la réalité.

### DESCRIPTION DETAILLEE

Il est précisé que dans le cadre de la présente invention, le terme « sur » ne signifie pas obligatoirement « au contact de ». Ainsi, par exemple, le dépôt d'une couche sur une autre couche, ne signifie pas obligatoirement que les deux couches sont directement au contact l'une de l'autre mais cela signifie que l'une des couches recouvre au moins partiellement l'autre en étant soit directement à son contact, soit en étant séparée d'elle par un film, encore une autre couche ou un autre élément.

Avant d'entamer une revue détaillée de modes de réalisation de l'invention, sont énoncées ci-après des caractéristiques optionnelles qui peuvent éventuellement être utilisées en association ou alternativement :
- Le substrat est choisi parmi un substrat isolant ou un substrat comportant une couche diélectrique en surface.
- L'étape de mise en relief de l'élément conducteur comprend une gravure configurée pour retirer une épaisseur d'une partie isolante du substrat correspondant à une hauteur h de l'élément conducteur en saillie. Avantageusement, selon l'agent de gravure utilisé, cette gravure peut-être isotrope ou anisotrope. Par exemple, une gravure humide sera plutôt isotrope, tandis qu'une gravure sèche sera plutôt anisotrope.
- L'étape de formation de l'empilement de couches est configurée de sorte que l'épaisseur de la couche électriquement résistive soit strictement inférieure à la hauteur h de l'élément conducteur en saillie.
- L'étape de formation de l'empilement de couches est configurée de sorte que l'épaisseur de l'empilement de couches soit strictement supérieure à la hauteur h de l'élément conducteur en saillie.
- L'étape de retrait partiel de la couche électriquement résistive est auto-limitée par la détection d'un accroissement du couple résistant.
- Une étape de retrait complet de la couche électriquement résistive est effectuée à l'issue de l'étape de croissance électrolytique.
- L'étape de retrait complet de la couche électriquement résistive comprend une gravure. Avantageusement, cette gravure peut-être aussi bien isotrope qu'anisotrope.
- Une étape de retrait de la couche électriquement conductrice est effectuée, à l'issue de l'étape de retrait complet de la couche électriquement résistive.
- L'étape de retrait de la couche électriquement conductrice comprend une gravure. Avantageusement, cette gravure peut-être aussi bien isotrope qu'anisotrope.
- L'empilement comprend une couche d'accroche ; celle-ci étant formée sur ladite face du substrat préalablement à l'étape de formation de la couche électriquement conductrice.
- Une étape de retrait de la couche d'accroche est effectuée, à l'issue de l'étape de retrait de la couche électriquement conductrice.
- L'étape de retrait de la couche d'accroche comprend une gravure. Avantageusement, cette gravure peut-être aussi bien isotrope qu'anisotrope.
- l'élément conducteur est entouré d'une au moins parmi une couche de barrière de diffusion et une couche d'isolation, l'étape de mise en relief étant configurée pour préserver la au moins une couche de barrière de diffusion et une couche d'isolation dans la partie de l'élément conducteur formant saillie.

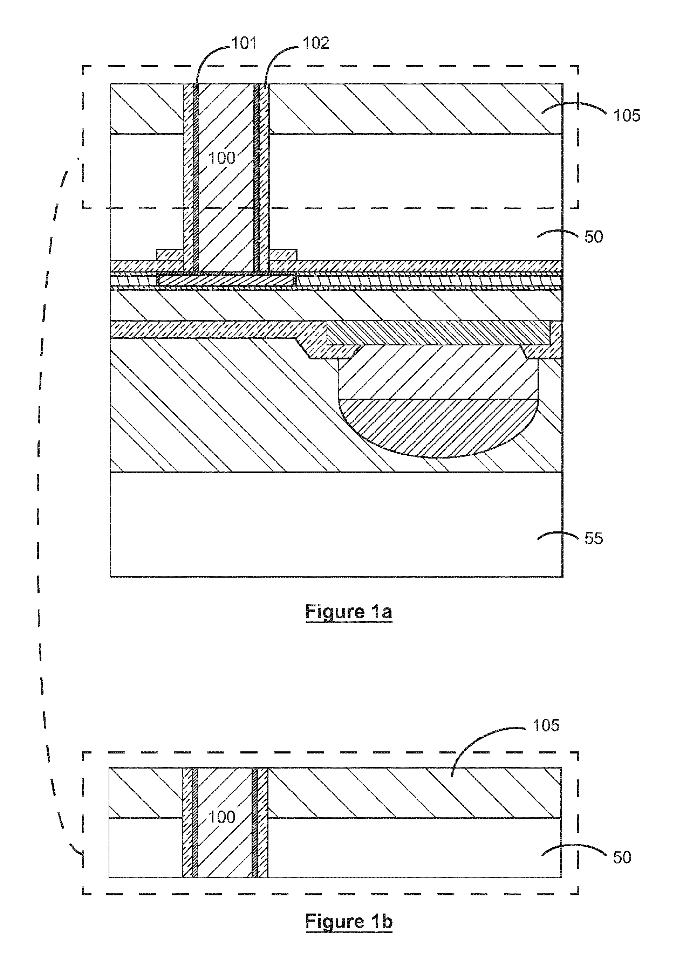

La **figure 1a** représente un substrat 50, de préférence de silicium, sur lequel un élément conducteur 100 a été, préalablement, réalisé notamment selon une technologie de type « via first » ou « via middle ». L'élément conducteur 100 est constitué, préférentiellement, d'un tronc central. Ce tronc central est, selon un mode de réalisation préférentiel, en un matériau métallique. Il comprend de préférence du cuivre. Le tronc central de l'élément conducteur 100 est, de manière particulièrement avantageuse, recouvert d'une couche faisant office de barrière de diffusion 101 et d'une couche d'isolation 102. Comme décrit précédemment, ce procédé nécessite un certain nombre d'étapes.

Pour des épaisseurs très faibles, la plaque comprenant le substrat 50 devient souple et peut casser au cours de l'opération d'amincissement, avant que les contraintes ne soient relaxées. Pour remédier à cet inconvénient, il est connu de coller le substrat 50 à une poignée support 55, afin de pouvoir maintenir et manipuler le substrat 50 aminci sans le casser. La poignée support 55 est, de préférence, un substrat de silicium ou de verre. Il s'ensuit un procédé d'amincissement du substrat 50 comprenant l'élément conducteur 100, s'effectuant classiquement par un « grinding ». Ensuite, une étape de relaxation des contraintes, par exemple, par polissage mécano-chimique. L'étape de « grinding » consiste donc à amincir le substrat 50 avec l'élément conducteur 100 à partir de la face arrière, et s'arrête à quelques microns au-dessus de l'arrière de l'élément conducteur 100, appelé « copper nails ». L'ouverture de l'arrière de l'élément conducteur peut, ensuite, être réalisée, de préférence par polissage mécano-chimique ou, selon des variantes, par gravure, par exemple à base d'hexafluorure de soufre (SF₆), ou attaque chimique à base d'hydroxyde de tetramethylammonium TMAH, ou encore, d'un mélange à base d'acide fluorhydrique et d'acide nitrique HF/HNO₃.

Il s'ensuit la formation d'une couche diélectrique 105 permettant d'isoler les futures interconnexions du substrat 50. Sur le substrat 50 est déposée la couche, avantageusement, en un matériau diélectrique 105. Cette couche diélectrique 105 peut, selon un mode de réalisation préférentiel, comprendre un diélectrique minéral choisi parmi le dioxyde de silicium (SiO₂) le nitrure de silicium (SiN), etc. Ce diélectrique possède l'avantage de pouvoir être déposé par dépôt chimique en phase vapeur CVD. Dans un procédé CVD typique, le substrat 50 est exposé à un ou plusieurs précurseurs en phase gazeuse, qui réagissent et/ou se décomposent à la surface du substrat 50 pour générer le dépôt désiré. La couche diélectrique 105 peut, suivant une autre variante de réalisation, comprendre une résine diélectrique. La couche diélectrique 105 est avantageusement étalée par une technique de centrifugation. On utilise, pour cela, une tournette qui aspire la plaque comprenant le substrat 50 afin qu'elle ne soit pas éjectée et qui permet, grâce à un réglage de la vitesse de rotation et de l'accélération, d'étaler uniformément la couche diélectrique 105. La vitesse de rotation est calculée pour obtenir une épaisseur constante sur toute la surface.

A l'issue de la formation de la couche diélectrique 105 sur le substrat 50, est réalisée l'étape d'ouverture de la face supérieure de l'élément conducteur 100. De manière préférentielle, cette étape est réalisée par polissage mécano chimique.

La **figure 1b** illustre une partie du dispositif comprenant l'élément conducteur 100, formé à partir du substrat 50. Le substrat 50 est recouvert par la couche diélectrique 105. L'élément conducteur 100 possède une ouverture sur la face supérieure, et sa paroi latérale est en contact sur toute son étendue avec la couche diélectrique 105.

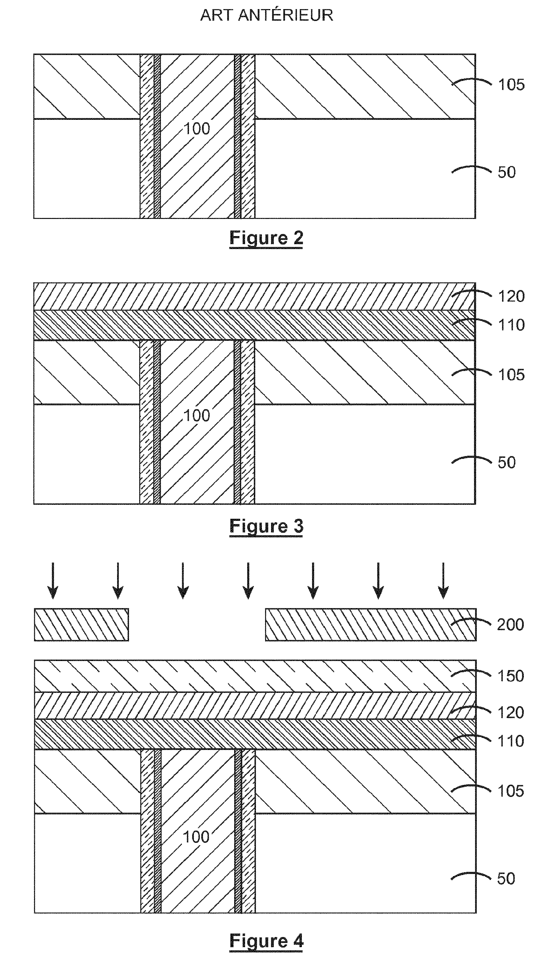

Les techniques actuelles de réalisation de plots d'interconnexion, à partir d'éléments conducteurs ou vias traversants (TSV), ont souvent recours à une étape de lithographie. Un tel exemple de mise en oeuvre est représenté dans les figures 2 à 8, illustrant les étapes technologiques du procédé standard de réalisation d'interconnexions.

La **figure 2** illustre le substrat 50, comprenant l'élément conducteur 100 et une couche diélectrique 105, à l'issue de l'étape d'ouverture de la face supérieure de l'élément conducteur 100, comme décrit précédemment.

La **figure 3** illustre l'étape de formation d'une première couche 110, dite d'accroche ou barrière, sur la couche diélectrique 105 et la face supérieure de l'élément conducteur 100. La couche d'accroche 110 est, de préférence, métallique à haute adhérence en un matériau, par exemple, à base de titane (Ti), de tantale (Ta) ou de chrome (Cr). Il s'ensuit la formation d'une couche 120 sur la couche d'accroche 110. Cette couche 120 est, préférentiellement, métallique. Elle est en un matériau choisi parmi le cuivre (Cu) ou l'or (Au). La couche 120 est, selon un mode de réalisation particulièrement avantageux, de résistivité plus faible que la première couche 110. A titre d'exemple, la couche 120 de cuivre présente une résistivité de l'ordre de 20.10⁻⁹ Ohm/m alors que la couche d'accroche 110 de titane présente une résistivité de l'ordre de 400.10⁻⁹ Ohm/m à une température de 300K; cela représente donc un facteur 20 de différence. La couche 120 peut être déposée par évaporation, pulvérisation ou voie chimique.

La **figure 4** illustre une étape de lithographie consistant, tout d'abord, en la formation d'une couche de résine 150 sur la couche 120. La couche de résine 150 est préférentiellement étalée sur la plaque à l'aide de la tournette, comme précédemment décrit pour la formation de la couche diélectrique 105.

La couche de résine 150 est ensuite séchée. Le séchage permet d'obtenir une couche solide, par évaporation du solvant contenu dans la résine liquide. Un masque 200, comprenant des motifs, est positionné au-dessus de la plaque comprenant le substrat 50. Le masque 200 est configuré de sorte à présenter des motifs au-dessus de l'élément conducteur 100.

Il s'ensuit une étape d'insolation de la couche de résine 150 à travers le masque 200. L'insolation permet d'irradier la couche 120, recouverte de la couche de résine 150 photosensible, à travers le masque 200, afin d'obtenir, après révélation, les motifs du masque 200 sur la couche 120.

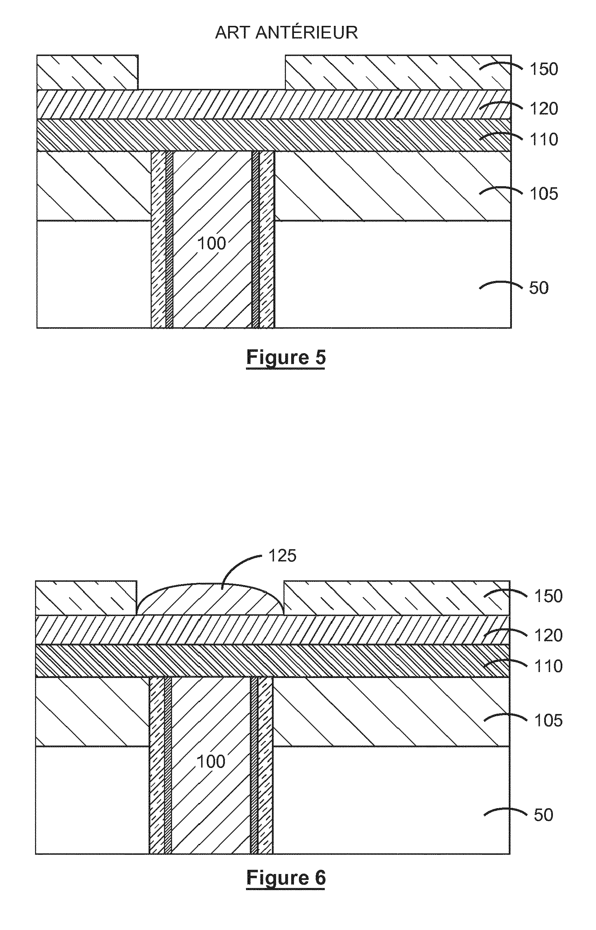

La **figure 5** illustre l'étape de révélation qui consiste à enlever la couche de résine 150 là où elle a été insolée (c'est-à-dire au niveau des motifs du masque 200). Le révélateur dépend de la résine utilisée. Le temps d'immersion dans la solution est défini à la seconde près, et le bain peut être homogénéisé grâce à un agitateur automatique. Préférentiellement, on stoppe la révélation en rinçant l'échantillon à l'eau désionisée. Après rinçage, une étape de recuit durcit la couche de résine 150 qui peut, dans certains modes de réalisation, résister aux attaquants chimiques tels que l'acide fluorhydrique.

A l'issue de cette étape, des motifs sont formés au-dessus de l'élément conducteur 100. La seconde couche 120 est, de manière avantageuse, uniquement découverte là où se situent les motifs du masque 200. Le reste de la plaque comprenant le substrat 50 est recouvert par la couche de résine 150.

La **figure 6** illustre l'étape de croissance par électrolyse à partir de la couche 120 sur les zones où se situent les motifs. La réalisation d'un plot d'interconnexion 125 sur l'élément conducteur 100, se fait par électrodéposition. Le métal utilisé est préférentiellement du cuivre, qui présente à la fois une bonne conductivité électrique et thermique. L'électrodéposition se réalise dans une cuve contenant un bain électrolytique dans lequel sont plongées deux électrodes reliées aux bornes d'un générateur. Le bain électrolytique comprend une solution chimique contenant des ions métalliques de charge positive. La croissance électrolytique ne pouvant s'effectuer directement sur l'élément conducteur 100, ce dernier est, de manière avantageuse, préalablement recouvert de la couche d'accroche 110, métallique à haute adhérence, et de la couche 120, métallique conductrice.

A l'issue de la croissance électrolytique, une excroissance est formée à la surface de la couche 120, correspondant au plot d'interconnexion 125. Ce plot 125 peut être en divers matériaux, par exemple en matériaux fusibles tels que des matériaux à base d'étain, ou non fusibles tels que des matériaux à base de cuivre ou en alliage Nickel/Or. Ainsi le procédé ne nécessite pas forcément une étape de refonte du plot 125.

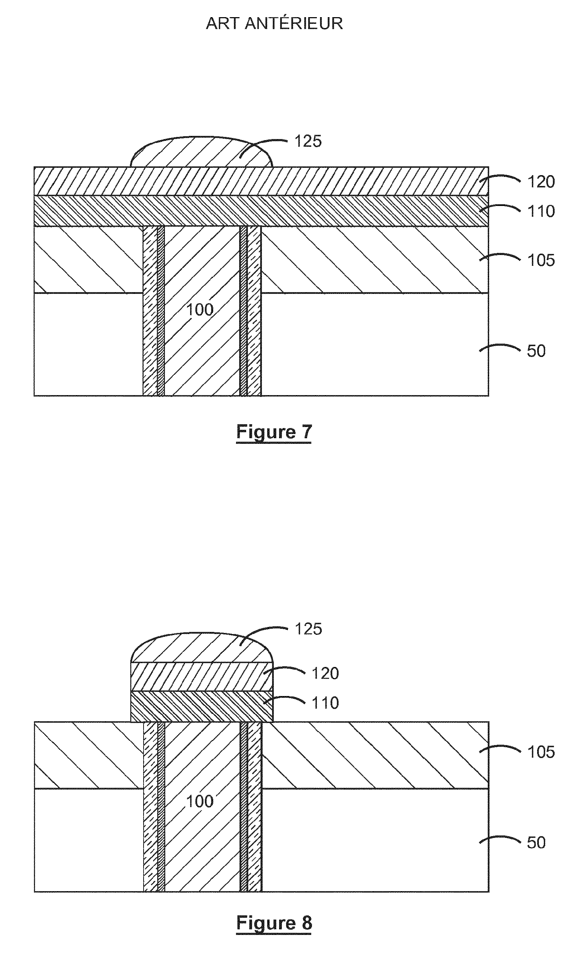

La **figure 7** illustre le dispositif à l'issue de l'étape de retrait de la couche de résine 150. La couche de résine 150 est retirée de sorte à découvrir la couche 120. Le retrait de la couche de résine 150 se fait, préférentiellement, au moyen d'un solvant chimique tel que l'acétone. Le retrait de la couche de résine 150 n'attaque pas le plot conducteur 125.

La **figure 8** illustre les étapes de retrait de la couche 120, puis de la couche d'accroche 110. Les étapes de retrait de la couche d'accroche 110 et de la couche 120 comprennent une attaque chimique. L'étape de retrait comprend une gravure, de préférence, anisotrope.

Les figures 9 à 15 décrivent les étapes du procédé selon l'invention pour une application préférentielle qui évite le recours à l'étape de lithographie décrite pour l'art antérieur et visant à la réalisation d'un plot d'interconnexion 125. De manière avantageuse, le procédé s'entend à la réalisation d'au moins un plot d'interconnexion 125.

Comme présenté dans la **figure 9****,** on part d'un substrat 50, avantageusement à base d'un semi-conducteur, en particulier de silicium (Si), et, préférentiellement, uniquement constitué de silicium. Le substrat 50 va, de manière privilégiée, constituer le support sur lequel est préalablement réalisé un élément conducteur 100. Bien entendu, selon l'invention, d'autres substrats à base de matériaux semi-conducteurs pourraient être utilisés et, par exemple, un substrat de silicium sur un isolant SOI (SOI, pour « silicon on insulator » en anglais), un substrat de silicium avec du silicium épitaxié, etc. L'élément conducteur 100 présente, préférentiellement, d'un tronc central. Ce tronc central est, selon un mode de réalisation préférentiel, en un matériau métallique. Il comprend de préférence du cuivre. Le tronc central de l'élément conducteur 100 est, de manière particulièrement avantageuse, recouvert d'une couche faisant office de barrière de diffusion 101 et d'une couche d'isolation 102.

Sur le substrat 50 est déposée une couche, avantageusement, en un matériau diélectrique 105. Cette couche diélectrique 105 peut, selon un mode de réalisation préférentiel, comprendre un diélectrique minéral choisi parmi le dioxyde de silicium (SiO₂), le nitrure de silicium (SiN), etc. Cette couche diélectrique 105 possède l'avantage de pouvoir être déposée par dépôt chimique en phase vapeur. Pour un diélectrique minéral, plusieurs techniques de dépôt sont envisageables (comme le dépôt en phase vapeur, le dépôt de couches atomiques ou encore le dépôt de couches atomiques assisté par plasma), mais ces techniques ne sont pas adaptées aux épaisseurs visées dans cette application entrainant une adaptation et donc un coût plus important. Il peut aussi s'agir d'un matériau organique (polymère) déposé à la tournette.

La **figure 10** illustre l'étape de mise en relief de l'élément conducteur 100 configurée pour que l'élément conducteur 100 traverse la couche diélectrique 105 et forme saillie au-delà de celle-ci. L'étape de mise en relief de l'élément conducteur 100 comprend, avantageusement, un retrait partiel de la couche diélectrique 105. Cette étape de mise en relief de l'élément conducteur 100 permet de créer une protrusion à partir dudit élément conducteur 100. Selon un mode de réalisation préférentiel, le retrait partiel de la couche diélectrique 105 est réalisé au moyen d'une solution chimique à base, par exemple, d'acide fluorhydrique (HF), dans le cas où la couche diélectrique 105 est en un matériau de type dioxyde de silicium (SiO₂). Selon une variante, le retrait de la couche diélectrique 105 est réalisé au moyen d'un plasma; et, notamment, d'un plasma oxygène dans le cas où la couche diélectrique 105 est en un matériau de type polymère. L'étape de mise en relief de l'élément conducteur 100 comprend une gravure, de préférence isotrope, configurée pour retirer une épaisseur de la couche diélectrique 105 correspondant à une hauteur h de l'élément conducteur 100 en saillie.

Pour un élément conducteur 100 ayant un diamètre compris entre 0.05 microns et 100 microns. A titre d'exemple, pour un via dont une des dimensions selon la section (généralement le diamètre) est de l'ordre de 5 à 10 microns, la couche diélectrique 105, en un matériau de type résine diélectrique, peut avoir une épaisseur comprise entre 100 nanomètres et 5 microns (nanomètre= 10⁻⁹ mètre et micromètre ou micron = 10⁻⁶ mètre). Selon cet exemple de réalisation, l'épaisseur de la couche diélectrique 105 retirée, correspondant à une hauteur h de l'élément conducteur 100 en saillie, est comprise entre 100 nanomètres et 4 microns. De manière préférentielle, l'épaisseur de la couche diélectrique 105 retirée est à adapter selon la hauteur d'élément conducteur 100 et l'épaisseur de la couche qui sera déposée ensuite.

Selon un mode de réalisation particulièrement avantageux, l'étape de mise en relief de l'élément conducteur 100 est configurée de sorte à conserver au moins l'une parmi la couche faisant office de barrière de diffusion 101 et la couche d'isolation 102 sur les flancs dudit élément conducteur. La gravure réalisée lors de l'étape de mise en relief est donc configurée de sorte à retirer la couche diélectrique 105 de manière sélective à au moins l'une parmi la couche faisant office de barrière de diffusion 101 et la couche d'isolation 102.

Les **figures 11a** et **11b** illustrent les étapes de formation d'une couche électriquement conductrice 120, d'une couche électriquement résistive 130, et, optionnellement d'une couche d'accroche 110.

La couche électriquement conductrice 120 (ou couche de base 120) comprend, préférentiellement, un matériau choisi parmi le cuivre (Cu), l'or (Au) ou le chrome (Cr). La couche électriquement conductrice 120 s'étend sur une épaisseur avantageusement comprise entre 10 nanomètres et 1 micron. De manière particulièrement avantageuse, l'épaisseur de la couche électriquement conductrice 120 est à ajuster selon la densité de courant voulue lors de l'étape de croissance électrolytique. Selon un mode de réalisation, la couche électriquement conductrice 120 est déposée sur la couche diélectrique 105. Optionnellement, préalablement à l'étape de formation de la couche électriquement conductrice 120, une étape de formation d'une couche d'accroche 110, sur la couche diélectrique 105, est réalisée. La couche d'accroche 110 comprend, avantageusement, un matériau choisi parmi le titane (Ti), le nitrure de titane (TiN), le titane de Tungstène-Titane (TiW), ou encore une bicouche de nitrure de tantale/Tantale (TaN/Ta). La couche d'accroche 110 s'étend sur une épaisseur avantageusement comprise entre 10 nanomètres et 500 nanomètres pour l'exemple de via donné précédemment.
Il s'ensuit une étape de formation de la couche électriquement résistive 130 (ou encore couche supérieure 130) sur la couche électriquement conductrice 120. La couche électriquement résistive 130 est, de manière particulièrement avantageuse, déposable sur un matériau choisi parmi le cuivre (Cu), l'or (Au) ou le chrome (Cr). Elle est, de préférence, compatible avec une étape de polissage mécano-chimique. Avantageusement, la couche électriquement résistive 130 possède une résistivité plus élevée que celle de la couche électriquement conductrice 120. A titre d'exemple, la couche électriquement conductrice 120 de cuivre présente une résistivité de l'ordre de 20.10⁻⁹ Ohm/m alors que la couche électriquement résistive 130 de titane présente une résistivité minimale d'environ 400.10⁻⁹ Ohm/m, à une température de 300K. Selon un mode de réalisation, la couche électriquement résistive 130 peut être un diélectrique et donc posséder une résistivité quasi infinie (ex : 10¹⁷ Ohm/m pour le verre), soit un facteur 20 ou plus.

La couche électriquement résistive 130 a préférentiellement l'avantage de pouvoir se graver chimiquement de manière sélective par rapport à la couche électriquement conductrice 120. Selon un mode de réalisation préférentiel, la couche électriquement résistive 130 comprend un matériau métallique, par exemple, à base de titane (Ti), nitrure de titane (TiN), tantale (Ta), nitrure de tantane (TaN) ou encore du titanate de tungstène (TiW). Selon une variante, la couche électriquement résistive 130 comprend un matériau diélectrique. Ce matériau est, par exemple, du nitrure de silicium (SiN). La couche électriquement résistive 130 est préférentiellement formée par un dépôt chimique en phase vapeur (CVD), ou par un dépôt chimique en phase vapeur assisté par plasma (ou PECVD, pour « Plasma-Enhanced Chemical Vapor Déposition » en anglais). La couche électriquement résistive 130 s'étend avantageusement sur une épaisseur comprise entre 10 nanomètres et 1 micron selon l'exemple de via donné précédemment.

Dans un mode de réalisation illustré en figure 11a, l'étape de formation de la couche électriquement résistive 130 est configurée pour que l'épaisseur de ladite couche électriquement résistive 130 soit strictement inférieure à la hauteur h de l'élément conducteur 100 en saillie, à l'issue de la mise en relief dudit élément conducteur 100 et que la somme des épaisseurs de l'empilement de couches 120, 130 soit inférieure à la hauteur h de l'élément conducteur 100 en saillie. Selon un autre mode de réalisation préférentiel illustré en figure 11b, l'étape de formation de la couche électriquement résistive 130 est configurée pour que l'épaisseur de ladite couche électriquement résistive 130 soit strictement inférieure à la hauteur h de l'élément conducteur 100 en saillie, à l'issue de la mise en relief dudit élément conducteur 100 et que la somme des épaisseurs de l'empilement de couches 120, 130 soit strictement supérieure à la hauteur h de l'élément conducteur 100 en saillie. Selon un exemple de réalisation, la hauteur h de l'élément conducteur 100 en saillie est de l'ordre de 500 nanomètres, l'épaisseur de la couche d'accroche 110 de 100 nanomètres, l'épaisseur de la couche électriquement conductrice 120 de 400 nanomètres et l'épaisseur de la couche électriquement résistive 130 de 300 nanomètres.

Les **figures 12a** et **12b** illustrent les étapes de retrait partiel de la couche électriquement résistive 130, au-dessus de l'élément conducteur 100 en saillie. L'étape de retrait comprend, préférentiellement, un polissage d'une partie de la couche électriquement résistive 130, qui permet d'ouvrir un accès à la couche électriquement conductrice 120, située au-dessus de l'élément conducteur 100 en saille. Le terme polissage s'entend de tout amincissement mécanique, y compris un meulage ou un polissage mécano-chimique. Cette étape de retrait est avantageusement configurée de sorte à amincir une couche, soit à retirer une épaisseur de ladite couche. De manière particulièrement avantageuse, la mise en relief de l'élément conducteur 100 crée une protrusion locale en surface permettant au polissage de consommer le matériau de la couche électriquement résistive 130 uniquement au-dessus de l'élément conducteur 100. L'étape de retrait partiel de la couche électriquement résistive 130 a l'avantage de créer un accès à la couche électriquement conductrice 120, ayant une conductivité plus importante que la couche électriquement résistive 130.

La figure 12a illustre un mode de réalisation dans lequel l'étape de retrait partiel de la couche résistive 130 s'arrête dès lors que la couche électriquement conductrice 120 est atteinte. Selon un mode de réalisation préférentiel, illustré en figure 12b, l'étape de retrait partiel de la couche résistive 130 s'arrête dès qu'un accroissement du couple résistant est détecté. Dans ce cas particulier, l'action mécanique du polissage mécano-chimique permet de polir en protrusion le matériau de la couche électriquement résistive 130, car le taux d'ouverture est très faible (inférieur à 1%) ; le taux d'ouverture correspondant à la surface en protrusion divisée par la surface totale de la plaque. Lorsque les protrusions sont polies, le matériau formant la couche électriquement résistive 130 représente alors la quasi-intégralité de la surface de la plaque, et la vitesse de polissage devient, dès lors, très faible. La couche électriquement résistive 130 devient une couche d'arrêt à l'étape de polissage mécano-chimique. Cela a l'avantage de permettre une meilleure uniformité sur la plaque.

Dès lors qu'au moins un accès à la couche électriquement conductrice 120 est localement ouvert au-dessus d'au moins un élément conducteur 100, il est avantageusement possible de procéder à une croissance électrolytique à partir de la couche électriquement conductrice 120, comme illustré en **figures 13a** et **13b**. Cette étape de croissance électrolytique a l'avantage de ne recourir à l'usage d'aucun masque. De manière particulièrement avantageuse, la différence de conductivité entre le matériau de la couche électriquement résistive 130 (très résistive) et la couche électriquement conductrice 120 (peu résistive) permet à l'électrolyte de se déposer uniquement, et de manière sélective, sur la couche électriquement conductrice 120. A titre d'exemple, le ratio de conductivité entre ces deux couches est de l'ordre de 20, comme précédemment évoqué concernant la résistivité. La croissance électrolytique se fait à partir de la couche électriquement conductrice 120, préférentiellement dans toutes les directions. L'étape de croissance électrolytique forme un plot d'interconnexion 125, de préférence de forme arrondie, au-dessus de l'élément conducteur 100.

La **figure 14** illustre l'étape de retrait de la couche électriquement résistive 130. Avantageusement, cette étape comprend une gravure. Préférentiellement, la gravure est isotrope. Selon un mode de réalisation où la couche électriquement résistive 130 est formée en un matériau à base de titane (Ti) et où la couche électriquement conductrice 120 est en un matériau à base de cuivre (Cu), l'étape de retrait de la couche électriquement résistive 130 comprend une gravure chimique, réalisée au moyen d'acide fluorhydrique (HF). Selon une variante où la couche électriquement résistive 130 est formée en un matériau à base de nitrure de silicium (SiN), l'étape de retrait de la couche électriquement résistive 130 comprend une gravure chimique, réalisée au moyen d'acide phosphorique (H₃PO₄).

La **figure 15** illustre l'étape de retrait de la couche électriquement conductrice 120. De manière avantageuse, l'étape de retrait de la couche électriquement conductrice 120 comprend une gravure. Cette gravure est, de préférence, anisotrope.

Optionnellement, dans le cas où une couche d'accroche 110 est formée sur la couche diélectrique 105, préalablement à la formation de la couche électriquement conductrice 120, une étape de retrait de la couche d'accroche 110 est réalisée. Préférentiellement, l'étape de retrait de la couche d'accroche 110 comprend une gravure. Cette gravure est, de préférence, anisotrope.

L'étape de mise en relief de l'élément conducteur 100 permet de créer une protrusion à partir dudit élément conducteur 100. Cette protrusion est ensuite utilisée lors de l'étape de retrait partiel de la couche électriquement résistive 130, pour ouvrir des accès à la couche électriquement conductrice 120, située au-dessus de l'élément conducteur 100, et ainsi réaliser un plot d'interconnexion 125 sur l'élément conducteur 100 au moyen d'une croissance électrolytique sans masque. Avantageusement, l'élément conducteur 100 conserve sur ses flancs, y compris au niveau de sa partie exposée, au moins l'une parmi la couche faisant office de barrière de diffusion 101 et la couche d'isolation 102.

La présente invention propose ainsi un procédé permettant d'économiser et surtout d'éviter le recours à une étape de lithographie tout en gagnant sur la précision d'alignement. Ce procédé est également compatible avec la réduction des dimensions d'éléments conducteurs ou vias traversants et des plots d'interconnexion associés. De plus, la forme arrondie des plots d'interconnexion est profitable à des procédés de report de puce (par exemple, de type WLUF pour « Wafer Level UnderFill », en anglais). En outre, les contraintes de positionnement liées à une étape d'alignement étant évitées, l'invention permet de réduire le coût des équipements nécessaires et ainsi le coût de réalisation de plots conducteurs.

Un autre aspect de l'invention concerne un dispositif micro-électronique comprenant un plot d'interconnexion. En particulier, un aspect non limitatif de l'invention concerne un dispositif micro-électronique comprenant un élément conducteur 100 avec au moins l'une parmi une couche faisant office de barrière de diffusion 101 et une couche d'isolation 102 . Avantageusement, au moins l'une parmi la couche faisant office de barrière de diffusion 101 et la couche d'isolation 102 affleure le bord dudit élément conducteur 100. Autrement dit, dans ce cas, l'une des couches 101, 102 ou les deux se prolongent jusqu'au bout de l'élément conducteur, jusqu'au niveau de hauteur de la face supérieure de cet élément. La partie saillante de l'élément conducteur est donc renforcée durant les étapes de fabrication d'un plot conducteur.

La présente invention n'est pas limitée aux modes de réalisation précédemment décrits mais s'étend à tout mode de réalisation conforme à son esprit.

## Revendications

1. Procédé de réalisation d'un plot d'interconnexion (125) sur un élément conducteur (100) comprenant une face supérieure et une paroi latérale ; le procédé étant réalisé à partir d'un substrat (50) dont au moins la face supérieure est isolante ; l'élément conducteur (100) traversant au moins une partie isolante du substrat (50), le procédé étant **caractérisé en ce qu'**il comprend la séquence d'étapes suivantes :
- une étape de mise en relief de l'élément conducteur (100) configurée pour que l'élément conducteur (100) forme saillie au-delà de la face supérieure isolante du substrat (50),
- une étape de formation au-dessus de la face supérieure isolante du substrat (50) d'un empilement de couches comportant au moins une couche électriquement conductrice (120) et une couche électriquement résistive (130) ; ladite couche électriquement résistive (130) ayant une résistivité supérieure à celle de la couche électriquement conductrice (120),
- une étape de retrait partiel de la couche électriquement résistive (130) configurée pour ouvrir au moins un accès à la couche électriquement conductrice (120), disposé au-dessus de l'élément conducteur (100) en saillie ; ladite étape comprenant un polissage de ladite couche électriquement résistive (130),
- une étape de croissance électrolytique sur la partie de la couche électriquement conductrice (120), disposée au-dessus de l'élément conducteur (100), de sorte à former au moins un plot d'interconnexion (125) sur ledit élément conducteur (100).

2. Procédé selon la revendication précédente dans lequel le substrat (50) est choisi parmi un substrat isolant ou un substrat comportant une couche diélectrique (105) en surface.

3. Procédé selon l'une des revendications 1 ou 2 dans lequel l'étape de mise en relief de l'élément conducteur (100) comprend une gravure, configurée pour retirer une épaisseur d'une partie isolante du substrat (50) correspondant à une hauteur h de l'élément conducteur (100) en saillie.

4. Procédé selon l'une quelconque des revendications précédentes dans lequel l'étape de formation de l'empilement de couches (120, 130) est configurée de sorte que l'épaisseur de la couche électriquement résistive (130) soit strictement inférieure à la hauteur h de l'élément conducteur (100) en saillie.

5. Procédé selon la revendication précédente dans lequel l'étape de formation de l'empilement de couches (120, 130) est configurée de sorte que l'épaisseur de l'empilement de couches (120, 130) soit strictement supérieure à la hauteur h de l'élément conducteur (100) en saillie.

6. Procédé selon la revendication précédente dans lequel l'étape de retrait partiel de la couche électriquement résistive (130) est auto-limitée par la détection d'un accroissement du couple résistant.

7. Procédé selon l'une des revendications précédentes comprenant une étape de retrait complet de la couche électriquement résistive (130), à l'issue de l'étape de croissance électrolytique.

8. Procédé selon la revendication précédente dans lequel l'étape de retrait complet de la couche électriquement résistive (130) comprend une gravure.

9. Procédé selon la revendication 7 comprenant une étape de retrait de la couche électriquement conductrice (120), à l'issue de l'étape de retrait complet de la couche électriquement résistive (130).

10. Procédé selon la revendication 9 dans lequel l'étape de retrait de la couche électriquement conductrice (120) comprend une gravure.

11. Procédé selon l'une des revendications précédentes dans lequel l'empilement comprend une couche d'accroche (110), celle-ci étant formée sur ladite face du substrat (50), préalablement à l'étape de formation de la couche électriquement conductrice (120).

12. Procédé selon la revendication 11 en combinaison avec l'une quelconque des revendications 9 ou 10 comprenant une étape de retrait de la couche d'accroche (110), à l'issue de l'étape de retrait de la couche électriquement conductrice (120).

13. Procédé selon la revendication 12 dans lequel l'étape de retrait de la couche d'accroche (110) comprend une gravure.

14. Procédé selon l'une des revendications précédentes dans lequel l'élément conducteur (100) est entouré d'une au moins parmi une couche de barrière de diffusion (101) et une couche d'isolation (102), l'étape de mise en relief étant configurée pour préserver la au moins une couche de barrière de diffusion (101) et une couche d'isolation (102) dans la partie de l'élément conducteur (100) formant saillie.

15. Dispositif comprenant au moins un plot d'interconnexion (125) obtenu par le procédé selon l'une quelconque des revendications précédentes.
